# FASCICULE DE BREVET EUROPEEN

(11) **EP 2 870 702 B1**
(45) Date de publication et mention de la délivrance du brevet: **07.09.2016**
(21) Numéro de dépôt: 13733291.2
(22) Date de dépôt: 01.07.2013
(51) Int. Cl.: H04B 3/28, H04B 3/30, H04L 25/02

(54) **DISPOSITIF DE RACCORDEMENT D'UN ORGANE ELECTRIQUE À UNE LIGNE DE COMMUNICATION**
VORRICHTUNG ZUM ANSCHLUSS EINES ELEKTRISCHEN ELEMENTS AN EINE KOMMUNIKATIONSLEITUNG
DEVICE FOR LINKING AN ELECTRICAL MEMBER TO A COMMUNICATION LINE

(30) Priorité: 06.07.2012 FR 1256501
(43) Date de publication de la demande: 13.05.2015
(73) Titulaire: SAGEM DEFENSE SECURITE, 92100 Boulogne-Billancourt (FR)
(72) Inventeur: GUILLOT, François, F-92100 Boulogne-Billancourt (FR); COURTEILLE, Jean-Marie, F-92100 Boulogne-Billancourt (FR); GOULLIER, Maxime, F-92100 Boulogne-Billancourt (FR); NOLLET, Michel, F-92100 Boulogne-Billancourt (FR)
(74) Mandataire: Lavialle, Bruno François Stéphane
(86) Numéro de dépôt international: PCT/EP2013/063829
(87) Numéro de publication internationale: WO 2014/005994

(56) Documents cités:
- FR-A1- 2 937 199
- US-B1- 7 575 478

## Description

L'invention concerne un dispositif de raccordement d'un organe électrique à une ligne de communication.

### ARRIERE PLAN DE L'INVENTION

Pour certifier un équipement destiné à être embarqué sur un aéronef, il est notamment nécessaire de vérifier le comportement de cet équipement lorsqu'il est placé dans des conditions environnementales similaires à celles qu'il est susceptible de rencontrer sur l'aéronef. L'équipement subit un ensemble de tests de qualification, au cours desquels on vérifie que l'équipement, lorsqu'il est soumis à ces conditions environnementales, fonctionne normalement, ou bien fonctionne dans un mode dégradé acceptable, ou bien n'est pas endommagé, ou bien encore ne perturbe pas le fonctionnement d'autres équipements. Cet ensemble de tests comprend généralement des tests climatiques (température, humidité, etc.), des tests mécaniques (vibrations, chocs, etc.), des tests de compatibilité électromagnétiques, de résistance à des impacts de foudre touchant l'aéronef, etc.

Parmi les tests de compatibilité électromagnétique, des tests dits de « susceptibilité aux radiofréquences » visent à vérifier le comportement d'un organe électrique lorsqu'il est exposé à un certain niveau d'énergie radiofréquence. Ces tests comprennent des tests dits de « susceptibilité conduite » au cours desquels des courants de fréquences balayées sur un large spectre sont injectés au niveau de câbles connectés à l'organe électrique.

Pour vérifier la résistance de l'organe électrique à des impacts de foudre, on prévoit des tests mis en oeuvre de manière similaire aux tests de susceptibilité conduite, ainsi que des tests d'injection de courant réalisée directement au niveau de connecteurs de l'équipement.

On exige de certains organes électrique réalisant des fonctions particulièrement critiques, par exemple un organe électrique utilisé dans un système de commandes de vol électriques, non seulement de ne pas être endommagé par ces courants injectés, mais en plus de fonctionner normalement au moment de l'injection.

Ainsi, il a été requis qu'un organe électrique soit capable d'émettre et de recevoir normalement des données sur une ligne de communication différentielle numérique, même lorsqu'un courant de plusieurs centaines de milliampères est injecté sur la ligne, à des fréquences variant entre 100 kHz et 400 MHz. Ce courant injecté génère notamment d'importantes perturbations en mode commun se propageant sur des conducteurs de la ligne.

Pour permettre à l'organe électrique de passer avec succès ce test, il pourrait être envisagé de monter sur l'organe électrique un dispositif de raccordement à la ligne de communication comprenant un premier transformateur à deux enroulements montés en série avec les conducteurs de la ligne, puis un second transformateur de type transformateur à point milieu pour isoler galvaniquement l'organe électrique de la ligne de communication. Le second transformateur comporterait un enroulement comprenant deux bornes de connexion classiques ainsi qu'une borne de connexion supplémentaire au milieu de l'enroulement. Ainsi, une perturbation en mode commun générée par l'injection de courant serait filtrée par les transformateurs et évacuée vers une masse mécanique de l'organe électrique via cette borne de connexion.

L'utilisation de ces transformateurs serait efficace, sauf dans le cas où la perturbation en mode commun se propagerait à une fréquence correspondant à une fréquence de résonance du dispositif de raccordement due à une composante inductive du premier transformateur et à une composante capacitive du second transformateur. A cette fréquence de résonance se traduisant par une forte baisse d'impédance de l'organe de réception et donc une augmentation du courant de mode commun, il existe un risque important que la perturbation en mode commun endommage des composants de l'organe électrique, ou bien interrompe la communication. Un exemple de l'art antérieur peut être trouvée dans US 7,575,478

### OBJET DE L'INVENTION

L'invention a pour objet un dispositif de raccordement pour raccorder un organe électrique à une ligne de communication différentielle, permettant de ne pas endommager l'organe électrique et de maintenir une communication sur la ligne, même lorsque l'organe électrique est soumis à un test de foudre ou de susceptibilité conduite consistant à injecter un courant de fréquence variable sur la ligne de communication.

### RESUME DE L'INVENTION

En vue de la réalisation de ce but, on propose un dispositif de raccordement d'un organe électrique à une ligne de communication comprenant au moins deux conducteurs pour porter des signaux différentiels, le dispositif de raccordement comportant au moins un composant d'interface échangeur de données relié à la ligne pour émettre et/ou recevoir des données et un moyen de liaison de l'organe électrique à la ligne, le dispositif de raccordement comportant en outre successivement, depuis le moyen de liaison jusqu'au composant d'interface, au moins :
- un premier transformateur agencé pour réaliser un filtrage en mode commun sur chaque conducteur de la ligne de communication ;
- un second transformateur agencé pour réaliser une isolation galvanique de manière à isoler de la ligne de communication au moins le composant d'interface ;
- un troisième transformateur monté en parallèle du deuxième transformateur et formé de deux enroulements munis de bornes parmi lesquelles des bornes non connectées au deuxième transformateur sont connectées à une masse mécanique de l'organe électrique ;
- un quatrième transformateur agencé pour réaliser une isolation galvanique de manière à isoler de la masse mécanique au moins le composant d'interface.

Lorsqu'un courant est injecté sur la ligne de communication, générant une perturbation en mode commun de fréquence égale à une fréquence de résonance due à une composante inductive du premier transformateur et à une composante capacitive du second transformateur, le troisième transformateur , qui présente une impédance nulle en mode commun, évacue la perturbation vers la masse mécanique de l'organe électrique quelle que soit la fréquence de celle-ci. Ainsi, une perturbation en mode commun se propageant à une fréquence de résonance du dispositif ne risque pas d'endommager des composants de l'organe électrique ni de perturber des échanges de données sur la ligne de communication.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- les figure 1 à 4 représentent des schémas électriques d'un dispositif de raccordement de l'invention selon quatre modes de réalisation différents ;
- la figure 5 représente un dispositif de raccordement de l'invention dans lequel des enroulements de transformateurs sont réalisés par des enroulements de pistes d'un circuit imprimé ;
- la figure 6 représente des enroulements de transformateurs d'un dispositif de raccordement de l'invention intégrés au sein d'un même composant discret.

### DESCRIPTION DETAILLEE DE L'INVENTION

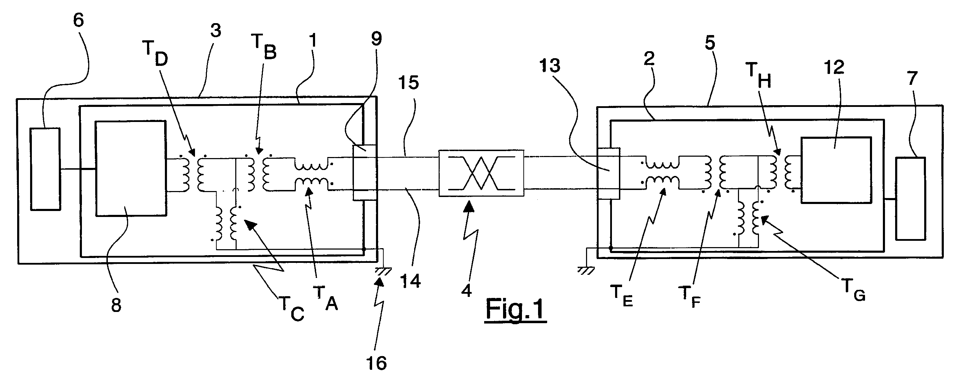

En référence à la figure 1, un dispositif de raccordement de l'invention 1, 2 selon un premier mode de réalisation est intégré dans un premier organe électrique 3 destiné à émettre des données sur une ligne de communication numérique différentielle 4, et dans un second organe électrique 5 destiné à recevoir ces données. Les données sont donc ici transmises dans une liaison simplex, c'est-à-dire dans un seul sens entre le premier organe électrique 3 qui émet les données et le second organe électrique 5 qui les reçoit.

Outre le dispositif de raccordement de l'invention, chacun des organes électriques 3, 5 comporte un module de contrôle 6, 7, par exemple un microcontrôleur ou un FPGA, dont une des fonctions est, dans le cas du premier organe électrique 3, de générer les données que le premier organe électrique 3 doit émettre, et dans le cas du second organe électrique 5, de traiter les données reçues par le second organe électrique 5, c'est-à-dire par exemple, de les interpréter, de les stocker, ou de les réémettre. Dans le premier organe électrique et le second organe électrique, les données sont respectivement générées et reçues par les modules de contrôle 6, 7 via les dispositifs de raccordement de l'invention 1, 2.

Les dispositifs de raccordement 1, 2 du premier organe électrique 3 et du second organe électrique 5 comportent chacun :
- un composant d'interface échangeur de données 8, 12 ;
- quatre transformateurs TA, TB, TC, TD et TE, TF, TG, TH ;
- un connecteur 9, 13.

Par composant d'interface échangeur de données, on entend un composant pouvant être soit émetteur, soit récepteur, soit à la fois émetteur et récepteur. Dans la suite de cette description, on distinguera un composant d'interface émetteur d'un composant d'interface récepteur. Il est bien évident que cette distinction n'empêche pas un composant d'interface émetteur d'être par ailleurs capable de recevoir des données, et un composant d'interface récepteur d'être par ailleurs capable d'en émettre.

Ici, le composant d'interface échangeur de données 8 est un composant d'interface émetteur, et le composant d'interface échangeur de données 12 est un composant d'interface récepteur.

Les composants d'interface émetteur 8 et récepteur 12 sont tous deux munis de résistances d'adaptation d'impédance, non représentées ici, pour optimiser l'émission et la réception de données sur la ligne de communication 4.

Les dispositifs de raccordement 1, 2 du premier organe électrique et du second organe électrique sont donc identiques, à l'exception du fait que, contrairement à celui du premier organe électrique, le composant d'interface 12 du second organe électrique 5 est destiné à recevoir des données et non à les émettre. On se contentera donc ici de décrire l'agencement et les avantages du dispositif de raccordement 1 du premier organe électrique 3, ceux-ci étant équivalents dans le second organe électrique 5.

Le composant d'interface émetteur 8 du dispositif de raccordement 1 du premier organe électrique 3 est donc agencé pour recevoir des données du module de contrôle 6 et les mettre en forme pour les rendre conformes au standard Ethernet. Ces données sont ensuite émises, via les transformateurs TA, TB, TC, TD et le connecteur 9, en mode différentiel, sur la ligne de communication 4 munie de deux conducteurs 14, 15.

Les quatre transformateurs TA, TB, TC, TD du dispositif de raccordement 1 sont chacun formés de deux enroulements munis de deux bornes dont une borne homologue identifiée par un point pour préciser le début de chacun des enroulements et donc le sens des courants circulant dans chaque enroulement.

Le transformateur TA est agencé de manière à ce que chacun de ses enroulements ait une borne reliée au connecteur 9 et soit monté en série avec un conducteur 14, 15 de la ligne de communication 4, et que les courants circulant dans chaque enroulement circulent dans le même sens. Le transformateur TA a ainsi une composante inductive qui forme un moyen de filtrage permettant de filtrer des perturbations en mode commun à hautes fréquences.

Le transformateur TB est agencé de manière à ce que les deux bornes d'un même enroulement de TB soient reliées chacune à une borne de TA non reliée au connecteur 9. Le transformateur TB permet d'isoler galvaniquement de la ligne de communication 4 des composants électriques situés au-delà du transformateur TB, parmi lesquels le composant d'interface émetteur 8. Les courants circulant dans chaque enroulement de TB circulent dans le même sens. Le transformateur TB a ainsi une composante capacitive qui forme un moyen de filtrage ne permettant que de limiter des perturbations en mode commun à basses fréquences.

Le transformateur TC est monté en parallèle du transformateur TB, et est connecté à une masse mécanique 16 de l'organe électrique 3 par ses deux bornes non connectées aux bornes du transformateur TB. Les courants circulant dans chaque enroulement du transformateur TC circulent dans un sens différent.

Lorsqu'une perturbation en mode commun, ayant une fréquence de résonance correspondant à une fréquence de résonance résultant de la composante inductive du transformateur TA et de la composante capacitive du transformateur TB, se propage sur les conducteurs 14, 15 de la ligne de communication 4, celle-ci est évacuée vers la masse mécanique 16 via le transformateur TC, sans endommager de composant électrique de l'organe électrique 3.

On note que le transformateur TC présente une impédance très importante en mode différentiel, et donc ne dégrade pas les données émises par le composant d'interface d'émission à destination du second organe électrique.

Enfin, le transformateur TD est agencé de manière à ce que les deux bornes d'un même enroulement du transformateur TD soient connectées chacune à une borne de l'enroulement du transformateur TB non connecté au transformateur TA, et de manière à ce que les deux bornes de l'autre enroulement du transformateur TD soient connectées au composant d'interface émetteur 8. Le transformateur TD permet d'isoler galvaniquement de la masse mécanique des composants électriques situés au-delà du transformateur TD, parmi lesquels le composant d'interface émetteur 8. Les courants circulant dans chaque enroulement du transformateur TD circulent dans le même sens.

Le dispositif de raccordement de l'invention tel que décrit ci-dessus permet donc, sans dégrader les données émises, d'assurer un filtrage efficace aux basses et hautes fréquences, et d'éliminer des perturbations en mode commun ayant une fréquence correspondant à une fréquence de résonance résultant des composantes capacitives et inductives du dispositif.

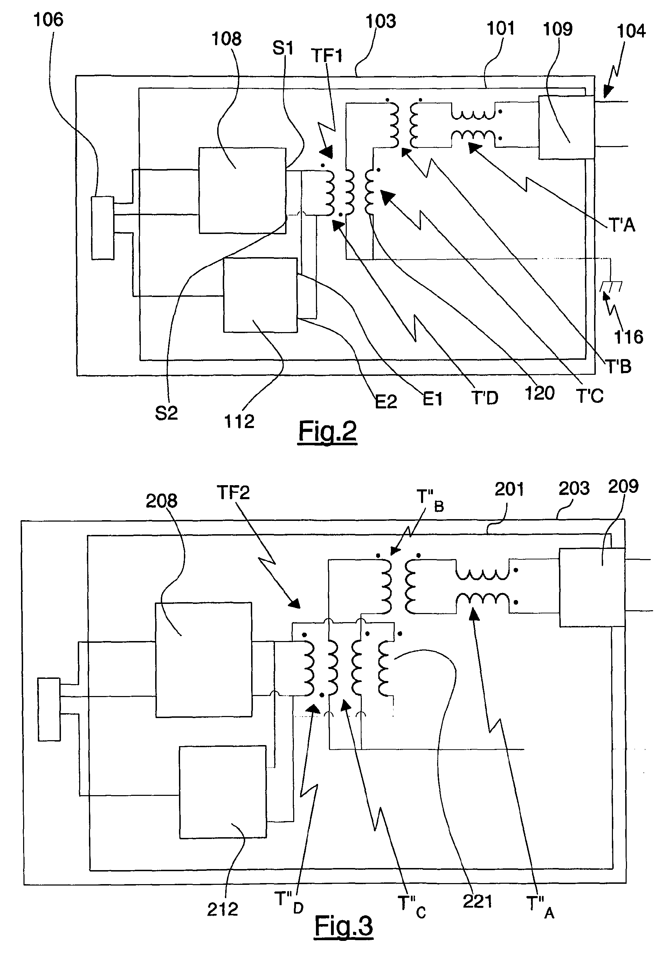

En référence à la figure 2, un dispositif de raccordement de l'invention 101 selon un deuxième mode de réalisation peut être intégré dans un premier organe électrique 103 destiné à émettre des données et à recevoir des données sur une ligne de communication numérique différentielle 104, ces données étant échangées avec un second organe électrique (non représenté sur la figure 2) lui aussi muni d'un dispositif de raccordement de l'invention. Les données sont ici échangées dans une liaison semi-duplex, c'est-à-dire qu'elles circulent dans un sens ou dans l'autre entre le premier organe électrique 103 et le second organe électrique, mais pas dans les deux sens simultanément.

Le premier organe électrique comporte bien sûr un module de contrôle 106 agencé notamment pour réaliser les fonctions remplies par les modules de contrôle d'émission et de réception décrites précédemment (génération, réception, traitement de données).

Le dispositif de raccordement de l'invention 101 du premier organe électrique 103 comporte ici un composant d'interface émetteur 108 et un composant d'interface récepteur 112, destinés à émettre et recevoir des données, ainsi que quatre transformateurs T'A, T'B, T'C, T'D, et un connecteur 109. Les composants d'interface sont munis de résistances d'adaptation d'impédance.

Le composant d'interface émetteur 108 comporte deux sorties S1, S2 connectées à deux entrées E1, E2 du composant d'interface récepteur 112, permettant au premier organe électrique alternativement d'émettre et de recevoir des données sur la ligne de communication 104.

Les quatre transformateurs T'A, T'B, T'C, T'D sont chacun formés de deux enroulements munis de deux bornes. Les transformateurs ont des fonctions similaires à celles décrites dans le premier mode de réalisation, et les courants circulant dans chaque enroulement circulent dans des sens similaires à ceux du premier mode de réalisation. Cependant, les transformateurs T'C et T'D sont ici chacun formés par deux enroulements parmi trois enroulements d'un dispositif de transformation TF1, ici un transformateur à trois enroulements.

Les transformateurs T'A et T'B sont agencés de manière similaire aux transformateurs TA et TB de la figure 1. Chaque enroulement du transformateur T'C a une borne reliée à une borne de T'B non reliée à T'A. Les bornes de T'C non reliées à T'B sont reliées à une masse mécanique 116 du premier organe électrique 103. Un enroulement 120 du transformateur T'D est commun avec un enroulement de T'C. Les bornes de l'autre enroulement de T'D sont reliées au sorties S1, S2 du composant d'interface émetteur 108 et aux entrées E1, E2 du composant d'interface récepteur 112.

Le transformateur à trois enroulements TF1 comporte donc un enroulement 120 utilisé par les deux transformateurs T'C, T'D ce qui, d'une part, simplifie le dispositif, et d'autre part, permet de réduire des pertes d'énergie de transformation (pertes Joule, pertes à vide, etc.). Cette réduction des pertes améliore la qualité des données transmises via les transformateurs, et améliore l'évacuation des perturbations en mode commun vers la masse mécanique 116 de l'organe électrique 103.

En référence à la figure 3, un dispositif de raccordement 201 de l'invention selon un troisième mode de réalisation est à nouveau intégré dans un premier organe électrique 203 pour échanger des données dans une liaison semi-duplex. Le dispositif de raccordement de l'invention 201 comporte à nouveau un composant d'interface émetteur 208 et un composant d'interface récepteur 212, quatre transformateurs T"A, T"B, T"C, T"D et un connecteur 209. Les transformateurs T"A, T"B, T"C, T"D ont des fonctions similaires à celles décrites dans le premier mode de réalisation. Ils sont formés d'enroulements dans lesquels les courants circulent dans des sens similaires à ceux des deux premiers modes de réalisation. Le troisième mode de réalisation est similaire au deuxième mode de réalisation, à l'exception du fait que le dispositif de raccordement est ici muni d'un dispositif de transformation TF2 à quatre enroulements, l'enroulement supplémentaire 221 étant monté en parallèle d'un enroulement de T"D dont les bornes sont reliées au composant d'interface émetteur 208 et au composant d'interface récepteur 212. Le transformateur à quatre enroulements TF2 est plus facile à équilibrer que le transformateur à trois enroulements TF1, c'est-à-dire qu'un dimensionnement du transformateur permettant d'assurer une circulation de courant symétrique à travers ce transformateur est plus facile à réaliser.

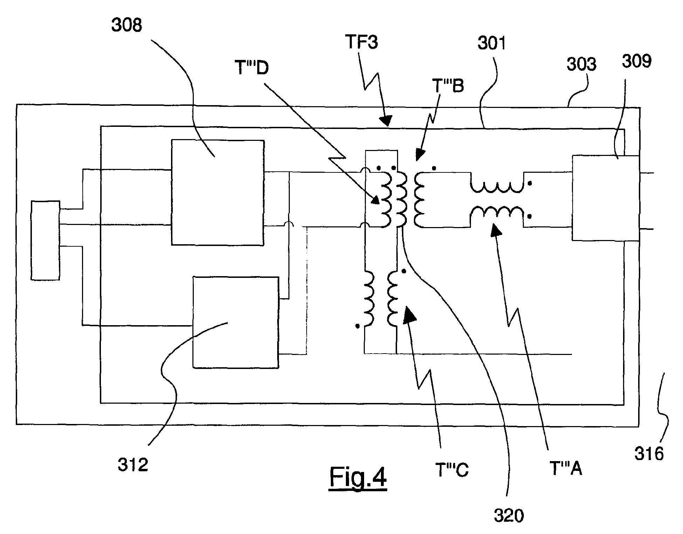

En référence à la figure 4, un dispositif de raccordement 301 de l'invention selon un quatrième mode de réalisation est à nouveau intégré dans un premier organe électrique 303 pour échanger des données dans une liaison semi-duplex. Le dispositif de raccordement comporte à nouveau un composant d'interface émetteur 308 et un composant d'interface récepteur 312, quatre transformateurs T"'A, T"'B, T"'C, T"'D, et un connecteur 309.

Les transformateurs T"'B et T"'D sont ici chacun formés par deux enroulements parmi trois enroulements d'un dispositif de transformation TF3, ici un transformateur à trois enroulements.

Le transformateur T"'A est agencé de manière similaire au transformateur TA de la figure 1. Le transformateur T"'B est agencé de manière à ce que les deux bornes d'un même enroulement du transformateur T"'B soient connectées chacune à une borne du transformateur T'''A non reliée au connecteur 309. Un enroulement 320 du transformateur T'''B non connecté au transformateur T"'A est commun aux transformateurs T"'B et T'''D. L'autre enroulement du transformateur T"'D est connecté aux composants d'interface émetteur 208 et récepteur 312. Chaque enroulement du transformateur T"'C a une borne connectée à l'enroulement 320. Les bornes du transformateur T"'C non reliées à l'enroulement 320 sont reliées à une masse mécanique 316 du premier organe électrique 303.

L'enroulement 320 est donc utilisé par les deux transformateurs T"'B et T"'D. Ceci permet à nouveau de simplifier le dispositif, de réduire les pertes, de faciliter l'équilibrage, mais aussi de supprimer un couplage capacitif existant, dans les modes de réalisation précédents, entre le transformateur TC ou T'C ou T''C et la masse mécanique de l'organe électrique.

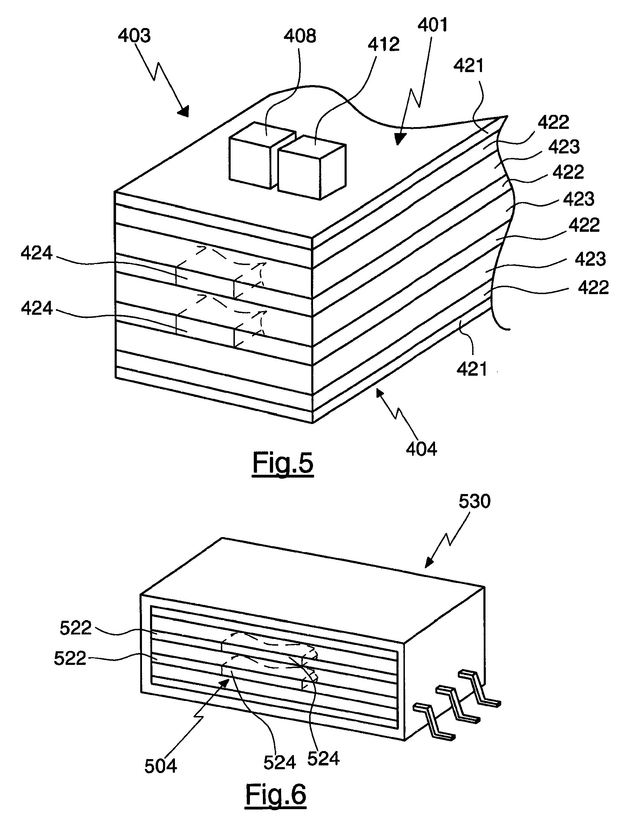

Pour fabriquer le dispositif de raccordement de l'invention, on peut prévoir de réaliser les enroulements des transformateurs en utilisant des enroulements de pistes de circuits imprimés. Avantageusement, en référence à la figure 5 qui représente des couches de vernis 421, de cuivre 422 et d'isolement 423 d'un circuit imprimé 404 d'un organe électrique 403, on répartit des enroulements de pistes 424 de transformateurs d'un dispositif de l'invention 401 sur des couches de cuivre internes du circuit imprimé 404, et on monte des composants d'interface émetteur 408 et récepteur 412 sur une couche de cuivre de surface. Les transformateurs ne nécessitent donc pas de noyau magnétique, et ne présentent donc pas de risque de saturation provoquée par un flux magnétique qui serait trop important pour le noyau. Une telle disposition permet en outre de réaliser le dispositif de raccordement sur une faible surface du PCB, d'assurer une reproductibilité industrielle satisfaisante, etc.

En référence à la figure 6, on peut aussi prévoir d'intégrer des enroulements de pistes 524 de transformateurs réalisés sur des couches de cuivre 522 d'un circuit imprimé 504 directement dans un composant discret 530, par exemple dans un boîtier BGA (pour « Ball Grid Ar-ray », souvent traduit en français par « boîtier à billes).

L'invention n'est pas limitée aux modes de réalisation particuliers qui viennent d'être décrits, mais, bien au contraire, couvre toute variante entrant dans le cadre de l'invention telle que définie par les revendications.

Bien que l'on ait utilisé le dispositif de raccordement selon le premier mode de réalisation, dans des premier et deuxièmes organes électriques communiquant via une liaison simplex, il est possible d'utiliser ce dispositif dans une liaison semi-duplex. On munira alors chaque organe électrique d'un composant d'interface échangeur de données émetteur et d'un composant d'interface échangeur de données récepteur, qui seront soit connectés entre eux de manière similaire aux dispositifs des autres modes de réalisation et connectés à un unique ensemble de transformateurs, soit connectés chacun à un ensemble de transformateurs. De même, il est possible d'utiliser les dispositifs de raccordement selon les autres modes de réalisation dans une liaison simplex. On munira alors chaque organe électrique uniquement d'un composant d'interface de type émetteur ou de type récepteur.

## Revendications

1. Dispositif de raccordement d'un organe électrique (3 ; 103 ; 203 ; 403) à une ligne de communication (4 ; 104) comprenant au moins deux conducteurs pour porter des signaux différentiels, le dispositif de raccordement comportant au moins un composant d'interface échangeur de données (8, 12 ; 108, 112) relié à la ligne pour émettre et/ou recevoir des données et un moyen de liaison (9, 13 ; 109) de l'organe électrique à la ligne, le dispositif de raccordement comportant en outre successivement, depuis le moyen de liaison jusqu'au composant d'interface, au moins :
- un premier transformateur (TA ; T'A ; T"A ; T"'A) agencé pour réaliser un filtrage en mode commun sur chaque conducteur de la ligne de communication ;
- un second transformateur (TB ; T'B ; T"B ; T"'B) agencé pour réaliser une isolation galvanique de manière à isoler de la ligne de communication au moins le composant d'interface ;
- un troisième transformateur (TC ; T'C ; T"C ; T"'C) monté en parallèle du deuxième transformateur et formé de deux enroulements munis de bornes parmi lesquelles des bornes non connectées au deuxième transformateur sont connectées à une masse mécanique de l'organe électrique ;
- un quatrième transformateur (TD ; T'D ; T"D ; T"'D) agencé pour réaliser une isolation galvanique de manière à isoler de la masse mécanique au moins le composant d'interface.

2. Dispositif de raccordement selon la revendication 1, dans lequel le troisième (T'C) et le quatrième transformateur (T'D) sont formés respectivement par un premier enroulement et un deuxième enroulement (120), et par le deuxième enroulement (120) et un troisième enroulement d'un dispositif de transformation (TF1) à trois enroulements.

3. Dispositif de raccordement selon la revendication 1, dans lequel le deuxième (T'''B) et le quatrième transformateur (T'''D) sont formés respectivement par un premier enroulement et un deuxième enroulement (320), et par le deuxième enroulement (320) et un troisième enroulement d'un dispositif de transformation (TF3) à trois enroulements.

4. Dispositif de raccordement selon la revendication 1, dans lequel le troisième transformateur (T"C) et le quatrième transformateur (T"D) sont formés respectivement par un premier enroulement et un deuxième enroulement, et par le deuxième enroulement et un troisième enroulement en parallèle avec un quatrième enroulement (221) d'un dispositif de transformation (TF2) à quatre enroulements.

5. Dispositif de raccordement selon la revendication 1, comportant un composant d'interface échangeur de données émetteur (108) et un composant d'interface échangeur de données récepteur (112), des sorties (S1, S2) du composant d'interface de type émetteur et des entrées (E1, E2) du composant d'interface de type récepteur étant connectées entre elles de manière à ce que les composants d'interface puissent émettre et recevoir des données sur la ligne de communication à travers les transformateurs.

6. Dispositif de raccordement selon la revendication 1, dans lequel au moins un des transformateurs est réalisé par des enroulements de pistes (424) d'un circuit imprimé (404).

7. Dispositif de raccordement selon la revendication 6, dans lequel tous les transformateurs sont réalisés par des enroulements de pistes (524) d'un circuit imprimé et intégrés au sein d'un même composant discret (530).

## Patentansprüche

1. Vorrichtung zum Anschluss eines elektrischen Elements (3; 103; 203; 403) an eine Kommunikationsleitung (4; 104), die mindestens zwei Leiter zum Übertragen von differentiellen Signalen umfasst, wobei die Anschlussvorrichtung mindestens ein Datenaustausch-Schnittstellenbauelement (8, 12; 108, 112) umfasst, das mit der Leitung zum Senden und/oder Empfangen von Daten verbunden ist, sowie ein Verbindungsmittel (9, 13; 109) zur Verbindung des elektrischen Elements mit der Leitung, wobei die Anschlussvorrichtung ferner nacheinander von dem Verbindungsmittel bis hin zum Schnittstellenbauelement mindestens umfasst:
- einen ersten Transformator (TA; T'A; T"A; T"'A), der so ausgebildet ist, dass er eine Gleichtaktfilterung auf jedem Leiter der Kommunikationsleitung durchführt;
- einen zweiten Transformator (TB; T'B; T"B; T"'B), der so ausgebildet ist, dass er eine galvanische Trennung zur Trennung mindestens des Schnittstellenbauelements von der Kommunikationsleitung durchführt;
- einen dritten Transformator (TC; T'C; T"C; T"'C), der parallel zum zweiten Transformator geschaltet und aus zwei Wicklungen gebildet ist, die mit Anschlüssen versehen sind, von denen nicht mit dem zweiten Transformator verbundene Anschlüsse mit einer mechanischen Masse des elektrischen Elements verbunden sind;
- einen vierten Transformator (TD; T'D; T"D; T"'D), der so ausgebildet ist, dass er eine galvanische Trennung zur Trennung mindestens des Schnittstellenbauelements von der mechanischen Masse durchführt.

2. Anschlussvorrichtung nach Anspruch 1, wobei der dritte (T'C) und der vierte Transformator (T'D) von einer ersten Wicklung und einer zweiten Wicklung (120) bzw. von der zweiten Wicklung (120) und einer dritten Wicklung einer Transformationsvorrichtung (TF1) mit drei Wicklungen gebildet sind.

3. Anschlussvorrichtung nach Anspruch 1, wobei der zweite (T"'B) und der vierte Transformator (T"'D) von einer ersten Wicklung und einer zweiten Wicklung (320) bzw. von der zweiten Wicklung (320) und einer dritten Wicklung einer Transformationsvorrichtung (TF3) mit drei Wicklungen gebildet sind.

4. Anschlussvorrichtung nach Anspruch 1, wobei der dritte Transformator (T"C) und der vierte Transformator (T"D) von einer ersten Wicklung und einer zweiten Wicklung bzw. von der zweiten Wicklung und einer zu einer vierten Wicklung (221) parallelen dritten Wicklung einer Transformationsvorrichtung (TF2) mit vier Wicklungen gebildet sind.

5. Anschlussvorrichtung nach Anspruch 1, umfassend ein Sender-Datenaustausch-Schnittstellenbauelement (108) und ein Empfänger-Datenaustausch-Schnittstellenbauelement (112), wobei Ausgänge (S1, S2) des Sender-Schnittstellenbauelements und Eingänge (E1, E2) des Empfänger-Schnittstellenbauelements derart miteinander verbunden sind, dass die Schnittstellenbauelemente Daten auf der Kommunikationsleitung durch die Transformatoren senden und empfangen können.

6. Anschlussvorrichtung nach Anspruch 1, wobei mindestens einer der Transformatoren durch Wicklungen von Leiterbahnen (424) einer Leiterplatte (404) gebildet ist.

7. Anschlussvorrichtung nach Anspruch 6, wobei alle Transformatoren durch Wicklungen von Leiterbahnen (524) einer Leiterplatte umgesetzt und innerhalb eines selben diskreten Bauelements (530) integriert sind.

## Claims

1. A connection device for connecting an electrical member (3; 103; 203; 403) to a communications line (4; 104) comprising at least two conductors for carrying differential signals, the connection device including at least one data exchange interface component (8, 12; 108, 112) connected to the line to send and/or receive data, and connection means (9, 13; 109) for connecting the electrical member to the line, the connection device also including in succession, going from the connection means to the interface components, at least:
• a first transformer (TA; T'A; T"A; T"'A) arranged to perform common mode filtering on each conductor of the communications line;
• a second transformer (TB; T'B; T"B, T"'B) arranged to perform electrical isolation so as to isolate the communications line at least from the interface component;
• a third transformer (TC; T'C; T"C; T"'C) connected in parallel with the second transformer and made up of two windings having terminals including terminals that are not connected to the second transformer and that are connected to frame ground of the electrical member; and
• a fourth transformer (TD; T'D; T"D; T"'D) arranged to provide electrical isolation so as to isolate at least the interface component from frame ground.

2. A connection device according to claim 1, wherein the third and fourth transformers (T'C, T'D) are formed respectively by a first winding and a second winding (120), and by the second winding (120) and a third winding of a three-winding transformer device (TF1).

3. A connection device according to claim 1, wherein the second and fourth transformers (T"'B, T"'D) are formed respectively by a first winding and a second winding (320), and by the second winding (320) and a third winding of a three-winding transformer device (TF3).

4. A connection device according to claim 1, wherein the third transformer (T"C) and the fourth transformer (T"D) are formed respectively by a first winding and a second winding, and by the second winding and a third winding in parallel with a fourth winding (221) of a four-winding transformer device (TF2).

5. A connection device according to claim 1, including a sender data exchange interface component (108) and a receiver data exchange interface component (112), outputs (S1, S2) of the sender type interface component and inputs (E1, E2) of the receiver type interface component being connected together in such a manner that the interface components can send and receive data over the communications line via the transformers.

6. A connection device according to claim 1, wherein at least one of the transformers is made by track windings (424) of a printed circuit (404).

7. A connection device according to claim 6, wherein all of the transformers are made by track windings (524) of a printed circuit and incorporated within a common discrete component (530).
